(19) Europäisches Patentamt
European Patent Office
Office européen des brevets

(11) **EP 1 122 552 B1**

(12) **EUROPÄISCHE PATENTSCHRIFT**

(45) Veröffentlichungstag und Bekanntmachung des Hinweises auf die Patenterteilung:
**09.01.2008 Patentblatt 2008/02**

(51) Int Cl.:
***G01R 33/385*** *(2006.01)*

(21) Anmeldenummer: **01200269.7**

(22) Anmeldetag: **25.01.2001**

(54) **MR- Gerät mit einer Gradientenspulen-Anordnung**

MR apparatus with gradient coil system

Appareil de résonance magnétique avec un système de bobines de gradient

(84) Benannte Vertragsstaaten:
**DE FR GB NL**

(30) Priorität: **03.02.2000 DE 10004765**

(43) Veröffentlichungstag der Anmeldung:
**08.08.2001 Patentblatt 2001/32**

(73) Patentinhaber:
• **Philips Intellectual Property & Standards GmbH 20099 Hamburg (DE)**
Benannte Vertragsstaaten:
**DE**
• **Koninklijke Philips Electronics N.V. 5621 BA Eindhoven (NL)**
Benannte Vertragsstaaten:
**FR GB NL**

(72) Erfinder: **Overweg, Johannes Adrianus, Dr., c/o Philips Corp. 52064 Aachen (DE)**

(74) Vertreter: **Volmer, Georg et al**
**Philips Intellectual Property & Standards GmbH**
**Postfach 50 04 42**
**52088 Aachen (DE)**

(56) Entgegenhaltungen:
**US-A- 4 581 580        US-A- 5 600 245**
**US-A- 5 706 813**

• **BOWTELL R ET AL: "MAGIC-ANGLE GRADIENT-COIL DESIGN" JOURNAL OF MAGNETIC RESONANCE. SERIES A, ACADEMIC PRESS, ORLANDO, FL, US, Bd. 115, Nr. 1, 1. Juli 1995 (1995-07-01), Seiten 55-59, XP000519712 ISSN: 1064-1858**
• **TURNER R: "GRADIENT COIL DESIGN: A REVIEW OF METHODS" MAGNETIC RESONANCE IMAGING, TARRYTOWN, NY, US, Bd. 11, Nr. 7, 1993, Seiten 903-920, XP000537049 ISSN: 0730-725X**

EP 1 122 552 B1

**Beschreibung**

Die Erfindung betrifft ein MR-Gerät

* mit einem Hauptfeldmagneten zur Erzeugung eines homogenen stationären Haupt-Magnetfeldes in einem Untersuchungsbereich,
* mit einer drei Gradientenspulen umfassenden Gradientenspulen-Anordnung zur Erzeugung von parallel zum Haupt-Magnetfeld verlaufenden Magnetfeldern mit in unterschiedlichen Richtungen verlaufenden Gradienten.

Außerdem betrifft die Erfindung eine Gradientenspulen-Anordnung für ein MR-Gerät.

Derartige MR-Geräte mit einer drei Gradientenspulen umfassenden Gradientenspulen-Anordnung sind seit langem bekannt. Die mit den einzelnen Gradientenspulen erzeugbaren Magnetfelder haben einen Gradienten, der entweder senkrecht oder parallel zum Hauptmagnetfeld verläuft. Zur Erzeugung eines in Richtung des Hauptmagnetfeldes verlaufenden Gradienten werden Gradientenspulen vom Helmholtz-Typ verwendet, die zwei räumlich getrennte Gruppen von Leitern aufweisen, die (bei geschlossenen Magneten mit einer zylinderförmigen Patientenöffnung) den Untersuchungsbereich kreisförmig umschließen. Die Gradientenspulen zur Erzeugung von senkrecht zum Hauptmagnetfeld verlaufenden Gradienten sind hingegen vom Sattelspulen-Typ. Bei MR-Geräten mit geschlossenen Magneten können sich die Leiter einer solchen Gradientenspule zwar auch auf der Oberfläche eines Zylinders befinden, doch umschließen die Leiter der einzelnen Segmente dieser Spule den Untersuchungsbereich nicht vollständig, sondern bedecken jeweils nur einen Teil des Umfangs der Zylinderfläche. Solche Spulen, Spulensysteme und MR-Gerate sind beispielsweise aus der veröffentlichung von Bowtell R1 et al, "Magic-Angle Gradient-Coil Design", JMR 115 (1995), p. 55-59 und aus der Patentschrift US5600245 bekannt.

Auf Grund des unterschiedlichen Aufbaus der Gradientenspulen haben diese auch unterschiedliche Eigenschaften. Beispielsweise folgt daraus ein unterschiedliches Wirbelstromverhalten, was unterschiedliche Impulsantworten zur Folge hat. Dadurch können bei der Erzeugung von schräg zum Hauptmagnetfeld verlaufenden Gradienten, bei denen verschiedene Gradientenspulen gleichzeitig wirksam sind, Artefakte in dem MR-Bild auftreten.

Weiterhin unterscheidet sich die Energie, die nötig ist, um mit den verschiedenen Gradientenspulen einen Gradienten der gleichen Größe zu erzeugen; die Gradientenspulen vom Helmholtz-Typ benötigen dafür weniger Energie als Gradientenspulen vom Sattelspulen-Typ. Dies hat zur Folge, dass die elektrische Leistung, die nötig ist, um innerhalb eines bestimmten Zeitraumes einen definierten Gradienten zu erzeugen, ebenfalls vom jeweiligen Spulentyp abhängen. Die GradientenVerstärker, die diese Ströme für die Gradientenspulen liefern müssen, werden also unterschiedlich belastet.

Man kann dem Rechnung tragen, in dem man Gradientenverstärker mit unterschiedlicher Maximalleistung einsetzt, wodurch die Unterschiede in den Gradientenkanälen sich noch vergrößern und die geschilderten Artefakte sich noch verstärken können. Statt dessen kann man aber auch identisch aufgebaute Gradienten-Verstärker verwenden. Die Leistungsreserven des Verstärkers für die mit der Richtung des Hauptmagnetfeldes zusammenfallende Gradientenrichtung werden dabei nicht voll ausgeschöpft werden (wenn man in allen drei Gradienten-Richtungen den gleichen Maximalwert des Gradienten erreichen will und dieselbe Flankensteilheit der Gradientenimpulse). Man hat jedoch eine einfachere Konfiguration und logistische Vorteile.

Aufgabe der vorliegenden Erfindung ist es, ein MR-Gerät der eingangs genannten Art so auszubilden, dass die Unterschiede zwischen den verschiedenen Gradientenspulen zumindest reduziert werden. Diese Aufgabe wird erfindungsgemäß durch die in Anspruch 1 angegebenen Maßnahmen gelöst.

Die Erfindung basiert auf der Erkenntnis, dass die zur Erzeugung von schräg zum Hauptmagnetfeld verlaufenden Gradienten erforderlichen Gradientenspulen weder reine Helmholtzspulen noch reine Sattelspulen sind (jedenfalls dann, wenn sie die gleiche - z.B. zylindrische-geometrische Form haben). Die erfindungsgemäßen gradientenspulen stellen vielmehr ein Gemisch aus beiden Spulentypen dar. Das bedeutet für eine zylindrische Spulenform beispielsweise, dass es ein Leitersegment gibt, das sich - ähnlich wie bei einer Helmholtzspule - über den gesamten Umfang (360°) des Zylinders erstreckt, während ein anderes Leitersegment der Gradientenspule sich nur über einen Teil des Umfangs erstreckt. Die Gradientenspulen für die verschiedenen Gradientenrichtungen unterscheiden sich daher in ihren Eigenschaften und in ihrem Aufbau nicht so stark voneinander wie bei einem MR-Gerät, bei dem die Gradienten entweder in Richtung des Hauptmagnetfeldes oder senkrecht dazu verlaufen.

Gemäß Anspruch 2 wird die Erfindung bei zylinderförmigen Gradientenspulen angewandt, wie sie bei geschlossenen Hauptfeldmagneten verwendet werden, die den Untersuchungsbereich vollständig umschließen und lediglich in der Mitte eine zylinderförmige Patientenöffnung frei lassen.

Eine andere Anwendungsmöglichkeit ist in Anspruch 3 angegeben, die sich für sogenannte offene Hauptfeldmagneten (bzw. open MRI) eignet. Dabei besitzt der Hauptfeldmagnet oberhalb und unterhalb des Untersuchungsbereich jeweils einen Magnetpol, und jede Gradientenspule besteht aus einem Paar von Spulen (der Begriff Gradientenspule ist in diesem Sinne weit auszulegen) oberhalb und unterhalb des Untersuchungsbereichs, die gleichzeitig und gegensinnig von einem Strom durchflossen werden. Bei derartigen Unterschieden ist der Unterschied zwischen den Spulen zur Erzeugung eines in Richtung des Hauptmagnetfeldes verlaufenden Gradienten und den Spulen zur Erzeugung eines dazu senkrechten Gradienten noch viel größer als bei einem MR-Gerät mit geschlossenem Magnetsystem.

Eine bevorzugte Ausgestaltung ist in Anspruch 4 angegeben. Die drei Gradientenspulen können dabei den gleichen Aufbau haben und sind lediglich relativ zueinander um 120° bezüglich der Symmetrieachse gedreht. Eine dafür geeignete weitere Ausgestaltung ist in Anspruch 6 angegeben. Wenn die drei Spulen mit der Richtung des Hauptmagnetfeldes einen Winkel von ca. 55° einschließen, verlaufen die Richtungen der drei Gradienten zueinander senkrecht. Dabei können sich aber induktive Kopplungen zwischen den drei Spulen ergeben, die sich bei einem kleineren oder einem größeren Winkel zwischen den Gradienten einerseits und der Richtung des Hauptmagnetfeldes andererseits vermeiden lassen. Eine aus drei Gradientenspulen zusammengesetzte Gradientenspulen-Anordnung für ein erfindungsgemäßes MK-gerät ist in Anspruch 7 definiert.

Die Erfindung wird nachstehend anhand der Zeichnungen näher erläutert. Es zeigen:

Fig. 1 ein MR-Gerät mit geschlossenem Hauptfeldmagneten, bei dem die Erfindung anwendbar ist,

Fig. 2 die Lage der Gradienten in bezug auf die Richtung des Hauptmagnetfeldes,

Fig. 3 einen Teil einer Abwicklung einer erfindungsgemäßen Gradientenspule,

Fig. 4 ein MR-Gerät mit offenem Magneten in schematischer Darstellung und

Fig. 5 den Stromverlauf bei einer für das MR-Gerät nach Fig. 4 geeigneten Gradientenspule.

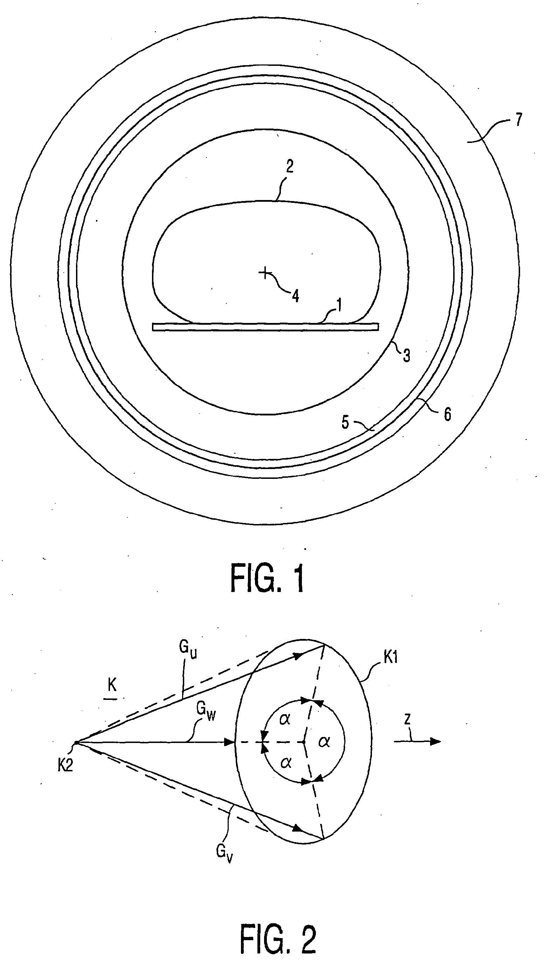

In Fig. 1 ist mit 1 eine Tischplatte zur Lagerung eines zu untersuchenden Objektes 2, beispielsweise eines Patienten bezeichnet. Der für die Untersuchung zur Verfügung stehende Raum - der Untersuchungsbereich - und die Tischplatte werden von einer nicht näher dargestellten Hochfrequenzspule umschlossen, die ihrerseits von einer Gradientenspulen-Anordnung 3 umschlossen wird. Obwohl die Gradientenspulen-Anordnung 3 im Querschnitt nur durch eine einzige Linie dargestellt ist, besteht sie aus drei sich umschließenden Gradientenspulen. Jede Gradientenspule umfaßt z.B. eine 2,5 mm starke Lage von Leitern, und die Lagen sind durch 0,5 mm starke Zwischenlagen voneinander isoliert.

Die Gradientenspulen-Anordnung 3 wird von einem dazu konzentrischen Kunststoffrohr 5 umschlossen, auf dessen Außenseite sich eine sogenannte aktive Abschirmung 6 für die Gradientenspulen-Anordnung 3 befindet. Die aktive Abschirmung 6 setzt sich ihrerseits wiederum aus drei Spulen mit einem kreisförmigen Querschnitt zusammen, von denen je eine von dem gleichen Strom durchflossen wird wie eine der Gradientenspulen. Daher kompensieren sich die Magnetfelder dieser Spulen im Außenbereich, d.h. in dem Metallgehäuse eines Kryostaten 9, so dass darin praktisch keine Wirbelstrome erzeugt werden.

In den Kryostaten befindet sich ein nicht näher dargestellter zylinderförmiger (geschlossener) Magnet, der ein zur Zeichenebene der Fig. 1 senkrechtes, stationäres und zumindest im Untersuchungsbereich homogenes Magnetfeld erzeugt. Die Symmetrieachse 4 der Komponenten 3,5,6 und 7 wird durch die zur Zeichenebene senkrechte Mittelachse dieser Komponenten gebildet. Die Symmetrieachse verläuft also in Richtung des Hauptmagnetfeldes.

Die drei Gradientenspulen der Gradientenspulen-Anordnung 3 können je ein Magnetfeld erzeugen, dessen in Richtung des Hauptmagnetfeldes verlaufende Komponente eine ortsabhängige Feldstärke hat, die im Isozentrum verschwindet, einem auf der Symmetrieachse 4 in der Mitte des Untersuchungsbereiches befindlichen Punkt. Die von den drei Gradientenspulen erzeugten Magnetfelder haben einen im Untersuchungsbereich im wesentlichen konstanten Gradienten mit voneinander abweichenden Gradientenrichtungen.

Dies ist in Fig. 2 angedeutet, die einen geraden Kreiskegel darstellt, d.h. einen Kegel, mit einem Kreis $K_1$ als Grundfläche und einer Spitze $K_2$, wobei das Lot von der Spitze $K_2$ auf den Kreis $K_1$ diesen in seinem Mittelpunkt trifft. Die Richtung des Lotes ist durch den Pfeil z angedeutet, der in Richtung des Hauptmagnetfeldes verläuft. Die mit den drei Gradientenspulen erzeugbaren Gradienten $G_u$, $G_v$ und $G_w$ sind Mantellinien des Kegels K, d.h. sie verbinden die Spitze mit dem Rand des Kreises $K_1$ und zwar so, dass sie an gleichmäßig auf dem Kreis verteilten Punkten enden (die Projektionen der Gradienten auf die Kreisfläche bilden also miteinander einen Winkel $\alpha = 120°$). Wenn der Winkel zwischen den Gradienten $G_u$, $G_v$, $G_w$ und dem Lot 55° (genauer 54,74°) beträgt, schließen die drei Gradienten einen Winkel von 90° miteinander ein, wie dies auch bei konventionellen Spulensystemen üblich ist, bei denen die Gradienten allerdings parallel oder senkrecht zum Hauptmagnetfeld verlaufen.

Jedoch kann der Winkel zwischen dem Lot und den Gradientenrichtungen unter Beibehaltung der Rotationssymmetrie auch größer oder kleiner und die Anordnung damit in anderer Weise optimiert werden. Beispielsweise kann der Winkel so groß gewählt werden, dass die induktive Kopplung zwischen den Spulen Null ist. In diesen Fällen würden die von den drei Gradientenspulen erzeugbaren Gradienten miteinander zwar einen von 90° verschiedenen Winkel bilden, doch könnte auch in einem solchen Fall jede beliebige Gradientenrichtung durch gleichzeitige Aktivierung einer oder mehrerer Gradientenspulen erzeugt werden, wobei die Gradienten der aktivierten Gradientenspulen vektoriell im Verhältnis der Ströme in diesen Spulen addiert werden.

Mit einer Gradientenspule, die die aus Fig. 1 ersichtliche Zylinderform hat und ein in Richtung der Symmetrieachse 4 verlaufendes Magnetfeld mit einem Gradienten mit einer schräg zur Symmetrieachse verlaufenden Richtung des Gradienten (z.B. $G_u$) erzeugen kann, lassen sich auch die beiden anderen Gradienten ($G_v$, $G_w$) erzeugen, indem die Gradientenspule lediglich um 120° um die Symmetrieachse 4 gedreht wird. Somit können die drei Gradientenspulen den gleichen Aufbau (und damit auch gleiche Eigenschaften) haben und die sie speisenden Gradientenverstärker können identisch aufgebaut sein, so dass sich für alle drei Gradientenkanäle identische Impulsantworten ergeben. Die eingangs geschilderten Bildartefakte können dabei also nicht auftreten.

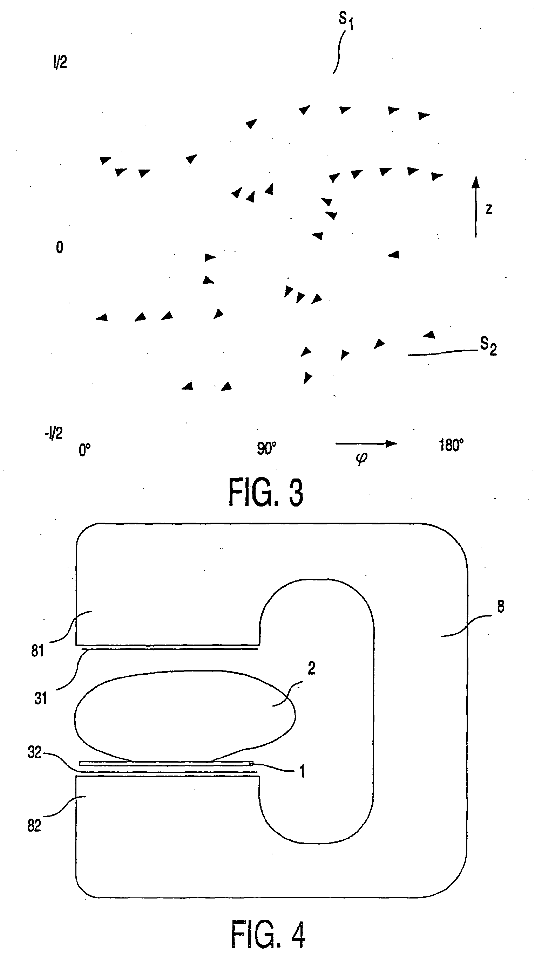

Der Aufbau einer dieser Gradientenspulen ergibt sich aus Fig. 3, die den erforderlichen Stromdichteverlauf darstellt und zwar für die Hälfte einer Abwicklung der Gradientenspule mit der Länge 1. Die Stromdichte ist dabei durch Strömungslinien symbolisiert, deren Dichte die Größe der Stromdichte wiedergibt und deren Richtung mit der Richtung der Stromdichte übereinstimmt. In horizontaler Richtung ist dabei die Umfangsrichtung φ angegeben und vertikal die Richtung z des Hauptmagnetfeldes. Der vollständige Stromdichteverlauf der Abwicklung ergibt sich, wenn man das Diagramm an der Linie φ = 0 oder φ = 180° spiegelt (wobei allerdings die Pfeile der Strömungslinien nicht zu spiegeln sind). Man erkennt, dass es einige Strömungslinien gibt, wie z.B. die Strömungslinie $S_1$, die sich über den gesamten Umfang (von φ = 0 bis φ = 360°) erstreckt, die aber nicht als Gerade in Umfangsrichtung verlaufen. Andererseits gibt es aber auch Stömungslinien - z.B. $S_2$ - die zwar ebenfalls in sich geschlossen sind, die sich aber nicht über den gesamten Umfang erstrecken.

Die Leiterbahnen in einer solchen Gradientenspule haben im wesentlichen denselben Verlauf wie die Strömungslinien. Es muß lediglich durch geeignete Unterbrechungen und Verbindungen mit benachbarten Leiterbahnen dafür gesorgt werden, dass der Strom von einer Leiterbahn zur anderen übergehen kann, so dass alle Leiterbahnen nacheinander von demselben Strom durchflossen werden.

Der in Fig. 3 dargestellte Stromdichtverlauf läßt sich auf einfache Weise ermitteln durch gewichtete Summierung der Stromdichteverläufe einer Gradientenspule mit einem in Richtung des Hauptmagnetfeldes verlaufenden Gradienten (die Strömungslinien verlaufen hierbei horizontal und symmetrisch zur Achse z = 0) und einer Sattelspule zur Erzeugung eines dazu senkrechten Gradienten. Summiert man die Stromdichtevektoren in miteinander korrespondierenden Punkten dieser bekannten Stromdichteverläufe, dann resultiert für diese Punkte ein Stromdichtevektor, der von dem Gewichtungsfaktor abhängt, mit dem die beiden Komponenten gewichtet werden. Gewichtet man die beiden erwähnten Komponenten im Verhältnis $1:\sqrt{2}$, dann ergibt sich aus der Addition die Stromdichte für eine Gradientenspule mit einem Gradienten, der unter einem Winkel von 54,74° zur z-Richtung verläuft.

Die Erfindung ist aber nicht nur bei dem in Fig. 1 dargestellten MR-Gerät mit einem geschlossenen Magnetsystem sondern auch bei einem MR-Gerät mit einem offenen Magnetsystem ("open MRI") anwendbar. Ein solches MR-Gerät ist in Fig. 4 dargestellt. Der Hautfeldmagnet ist darin mit 8 bezeichnet. Zwischen den einander zugewandten Polen 81 und 82 des Hauptmagneten 8 wird ein vertikal verlaufendes Hauptmagnetfeld erzeugt. Die Gradientenspulen-Anordnung besteht aus zwei Teilen 31 und 32, die je drei im wesentlichen ebene Spulen umfassen. Je eine Spule aus dem oberen und dem unteren Teil, die gleichzeitig von einem Strom durchflossen werden, bilden zusammen eine Gradientenspule. Dadurch wird ein vertikal verlaufendes Magnetfeld mit einem Gradienten erzeugt, dessen Richtung mit der Senkrechten einen Winkel von z.B. 55° bildet (vgl. Fig. 2).

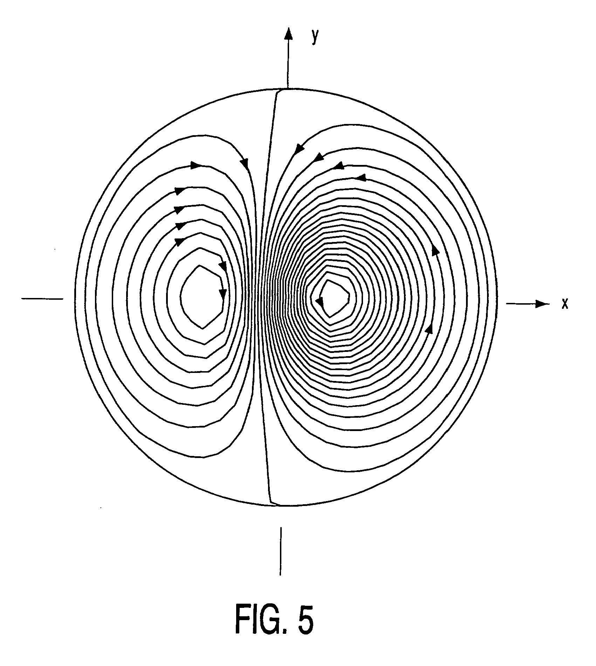

Die Fig. 5 zeigt den Stromdichteverlauf für eine dieser Spulen. Man erkennt zwei in horizontaler Richtung gegeneinander versetzte Gruppen von in sich geschlossenen Strömungslinien, wobei die rechte Gruppe einen ausgedehnteren Bereich umschließt als die linke und eine höhere Strömungsliniendichte hat. Infolgedessen ergibt sich unter anderem ein von rechts nach links verlaufender Gradient des Magnetfeldes. Wie bereits gesagt, bildet diese Spule zusammen mit einer weiteren Spule auf der anderen Seite des Untersuchungsbereichs eine Gradientenspule. Diese andere Spule ist identisch mit der in Fig. 5 dargestellten Spule jedoch ist sie gegenüber dieser um 180° gedreht (um eine zur Zeichenebene senkrechte Achse durch den Mittelpunkt der kreisförmigen Außenkontur der Spule). Außerdem haben in dieser anderen Spule die Strömungslinienmuster einen entgegengesetzten Umlaufsinn. Durch ein solches Spulenpaar wird daher in dem Untersuchungsbereich ein Magnetfeld erzeugt, dessen z-Komponente (die senkrecht zur Zeichenebene der Fig. 5 und in Richtung des Hauptmagnetfeldes verläuft) einen Gradienten hat, der mit der z-Achse einen Winkel von 55° einschließt und eine in x-Richtung verlaufende Komponente aufweist.

Auch in diesem Fall läßt sich der Stromdichteverlauf durch eine gewichtete Summierung der Stromdichteverläufe einer $G_z$-Spule (das ist eine Spule zur Erzeugung eines senkrecht zu ihrer Oberfläche verlaufenden Gradienten mit kreisförmigen zueinander konzentrischen Strömungslinien) und einer $G_x$ bzw. Gy-Spule (das ist eine Spule mit zwei halbkreisförmigen, bezüglich der x- bzw. y-Achse in Fig. 5 spiegelbildlichen Mustern von Strömungslinien). Die Spule gemäß Fig. 5, die aus dieser gewichteten Summierung resultiert, benötigt zwar mehr Energie um einen definierten Gradienten zu erzeugen als die erwähnte $G_z$-Spule, jedoch nur 80% der Energie, die die erwähnten $G_x$ bzw. Gy Spulen für die Erzeugung eines solchen Gradienten benötigen. Mit denselben Gradientenverstärkern kann daher ein um 10% stärkerer Gradient oder eine um 20% verkürzte Anstiegszeit erreicht werden.

Für die beiden anderen Spulenpaare gilt das zuvor gesagte entsprechend. Der einzige Unterschied ist, dass diese Spulenpaare gegenüber der Darstellung nach Fig. 5 um 120° (bezogen auf das Zentrum der Spulen) gedreht werden müssen.

Die Erfindung wurde vorstehend anhand von Ausführungsbeispielen erläutert, bei denen die Gradientenspulen die Form von Kreisen bzw. von Zylindern haben. Die Erfindung ist jedoch auch bei MR-Geräten anwendbar, die eine von der Rotationssymmetrie abweichende Form haben. Bei solchen Gradientenspulen müssen die erzeugten Gradienten nicht rotationssymmetrisch zur Richtung des Magnetfeldes verlaufen. Gleichwohl können diese Gradientenspulen Vorteile haben gegenüber Gradientenspulen mit parallel oder senkrecht zum Magnetfeld verlaufenden Gradienten.

Der Stromdichteverlauf für die drei Spulen einer aktiven Abschirmung (8 in Fig 2) läßt sich in analoger Weise durch gewichtete Summierung der Stromdichteverläufe der Basis Spulentypen ermitteln, wie oben für die Gradientenspulen erläutert. Sie erzeugen daher entsprechend orientierte Gradienten. Alle Spulen können auf gleiche Weise durch eine nichtleitende Struktur (5 in Fig 1) gehalten werden wie konventionelle Spulen.

**Patentansprüche**

1. MR-Gerät

   • mit einem Hauptfeldmagneten (8) zur Erzeugung eines homogenen stationären Haupt-Magnetfeldes in einem Untersuchungsbereich,
   • mit einer drei Gradientenspulen umfassenden Gradientenspulen-Anordnung (3;31,32) zur Erzeugung von parallel zum Haupt-Magnetfeld verlaufenden Magnetfeldern mit in unterschiedlichen Richtung verlaufenden Gradienten,

   **dadurch gekennzeichnet dass**
   die Stromdichteverläufe der einzelnen Gradienten-Spulen jeweils der gewichteten Summe der Stromdichteverläufe einer Spule mit in Richtung des Haupt-Magnetfeldes verlaufendem Gradienten und einer Spule mit einem dazu senkrechten Gradienten entsprechen, so dass die Gradienten ($G_u$, $G_v$, $G_w$) mit der Richtung (z) des Haupt-Magnetfeldes von 0° und von 90° verschiedene Winkel einschließen.

2. MR-Gerät nach Anspruch 1,
   **gekennzeichnet durch**
   eine den Untersuchungsbereich umschließende Zylinderform der Gradientenspulen (3), wobei die Zylinderachse (4) in der Richtung des Haupt-Magnetfeldes verläuft.

3. MR-Gerät nach Anspruch 1,
   **dadurch gekennzeichnet**
   **dass** jede Gradientenspule durch ein Paar von beiderseits des Untersuchungsbereiches befindlichen Spulen (31,32) gebildet wird, die im Betriebszustand gegensinnig vom Strom durchflossen werden und ein in Richtung des Haupt-Magnetfeldes verlaufendes Magnetfeld erzeugen

4. MR-Gerät nach Anspruch 1,
   **gekennzeichnet durch**
   eine zur Richtung des Haupt-Magnetfeldes rotationssymmetrische Ausrichtung der Gradientenspulen ($G_u$, $G_v$, $G_w$).

5. MR-Gerät nach Anspruch 1,
   **dadurch gekennzeichnet,**
   **dass** auf der vom Untersuchungsbereich abgewandten Seite der Spulen der Gradienten-Spulen-Anordnung eine aktiven Abschirmung (6) mit drei Spulen vorgesehen ist, die entsprechend orientierte Gradienten erzeugen wie die Spulen der Gradientenspulen-Anordnung und das Magnetfeld im Außenbereich kompensieren.

6. MR-Gerät nach Anspruch 4,
   **dadurch gekennzeichnet,**
   **dass** die Gradienten mit der Richtung des Haupt-Magnetfeldes einen Winkel zwischen 45° und 65°, vorzugsweise von 55° einschließen.

7. Gradientenspulen-Anordnung für ein MR-Gerät nach Anspruch 1 mit drei Gradientenspulen zur Erzeugung von Magnetfeldern mit rotationssymmetrisch zu einer Symmetrieachse (4) ausgerichteten Gradienten, wobei die Gradientenspulen einen solchen Aufbau haben, dass die Gradienten ($G_u$, $G_v$, $G_w$) mit der Richtung (z) der Symmetrieachse (4) jeweils von 0° und von 90° verschiedene Winkel einschließen.

8. Gradientenspulen-Anordnung für ein MR-Gerät nach Anspruch 7,
   wobei die Gradientenspulen den gleichen Aufbau haben.

**Claims**

1. An MR apparatus comprising

   - a main field magnet (8) for generating a uniform, steady main magnetic field in an examination zone,
   - a gradient coil system (3; 31, 32) which comprises three gradient coils for generating magnetic fields which extend parallel to the main magnetic field and have gradients extending in different directions,

   **characterized in that**
   the current density gradients of the individual gradient coils each correspond to a weighted sum of the current density gradients of a coil having gradients extending in the direction of the main magnetic field and a coil having gradients extending perpendicularly thereto, such that the gradients ($G_u$, $G_v$, $G_w$) enclose angles other than 0° and 90° with the direction (z) of the main magnetic field.

2. An MR apparatus as claimed in claim 1, **characterized by** a cylindrical shape of the gradient coils (3), which shape encloses the examination zone, wherein the cylinder axis (4) extends in the direction of the main magnetic field.

3. An MR apparatus as claimed in claim 1, **characterized in that** each gradient coil is formed by a pair of coils (31, 32) which are situated on either side of the examination zone and are traversed by the current in opposite directions in the operating condition, said coils generating a magnetic field that extends in the direction of the main magnetic field.

4. An MR apparatus as claimed in claim 1, **characterized by** a rotationally symmetrical orientation of the gradient coils ($G_u$, $G_v$, $G_w$) with respect to the direction of the main magnetic field.

5. An MR apparatus as claimed in claim 1, **characterized in that** at the side of the coils of the gradient coil system which is remote from the examination zone there is provided an active shield (6) with three coils which generate correspondingly oriented gradients as do the coils of the gradient coil system, thus compensating for the magnetic field in the external region.

6. An MR apparatus as claimed in claim 4, **characterized in that** the gradients enclose an angle of between 45° and 65°, preferably of 55°, with the direction of the main magnetic field.

7. A gradient coil system for an MR apparatus as claimed in claim 1, with three gradient coils for generating magnetic fields with gradients that are directed so as to be rotationally symmetrical to an axis of symmetry (4), wherein the gradient coils are constructed such that the gradients ($G_u$, $G_v$, $G_w$) enclose angles other than 0° and 90° with the direction (z) of the axis of symmetry (4).

8. A gradient coil system for an MR apparatus as claimed in claim 7, wherein the gradient coils are of the same construction.

## Revendications

1. Appareil de résonance magnétique

avec un aimant de champ principal (8) pour la production d'un champ magnétique principal stationnaire homogène dans une zone à examiner,
avec un système de bobines de gradient comprenant trois bobines de gradient (3; 31,32) pour la production de champs magnétiques s'étendant parallèlement au champ magnétique principal avec des gradients s'étendant dans différentes directions,
**caractérisé en ce**
**que** les tracés de densité du courant des différentes bobines de gradient correspondent respectivement à la somme pondérée des tracés de densité de courant d'une bobine avec des gradients s'étendant en direction du champ magnétique principal et une bobine avec un gradient perpendiculaire à celle-ci de telle sorte que les gradients ($G_u$, $G_v$, $G_w$) forment avec la direction (z) du champ magnétique principal des angles différents de 0° et de 90°.

2. Appareil de résonance magnétique selon la revendication 1,
**caractérisé par**
une forme cylindrique des bobines de gradient (3), renfermant la zone à examiner, l'axe cylindrique (4) s'étendant dans la direction du champ magnétique principal.

3. Appareil de résonance magnétique selon la revendication 1,
**caractérisé en ce**
**que** chaque bobine de gradient est formée par une paire de bobines (31, 32) se trouvant de part et d'autre de la zone à examiner, qui sont traversées par du courant en sens opposé à l'état de fonctionnement et produisent un champ magnétique s'étendant dans la direction du champ magnétique principal.

4. Appareil de résonance magnétique selon la revendication 1,
**caractérisé par**
une orientation des bobines de gradient ($G_u$, $G_v$, $G_w$) à symétrie de rotation par rapport à la direction du champ magnétique principal.

5. Appareil de résonance magnétique selon la revendication 1,
**caractérisé en ce**
**qu'**il est prévu sur la face des bobines du systèmes de bobines de gradient opposée à la zone à examiner une protection active (6) avec trois bobines qui produisent des gradients orientés de manière correspondante comme les bobines du système de bobines de gradient et compensent le champ magnétique à l'extérieur.

6. Appareil de résonance magnétique selon la revendication 4,

**caractérisé en ce**
**que** les gradients forment un angle entre 45° et 65°, de préférence de 55° avec la direction du champ magnétique principal.

7. Système de bobines de gradient pour un appareil de résonance magnétique selon la revendication 1 avec trois bobines de gradient pour la production de champs magnétiques avec des gradients orientés à symétrie de rotation par rapport à un axe de symétrie (4), les bobines de gradient ayant une conception telle que les gradients ($G_u$, $G_v$, $G_w$) forment avec la direction (z) de l'axe de symétrie (4) des angles respectivement différents de 0° et 90°.

8. Système de bobines de gradient pour un appareil de résonance magnétique selon la revendication 7, les bobines de gradient ayant la même conception.

FIG. 1

FIG. 2

FIG. 3

FIG. 4

FIG. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

•  US 5600245 A

**In der Beschreibung aufgeführte Nicht-Patentliteratur**

•  **BOWTELL R1 et al.** Magic-Angle Gradient-Coil Design. *JMR,* 1995, vol. 115, 55-59